# EUROPEAN PATENT APPLICATION

(11) **EP 3 608 982 A1**
(43) Date of publication of application: **12.02.2020**
(21) Application number: 18187974.3
(22) Date of filing: 08.08.2018
(51) Int. Cl.: H01L 51/44

(54) **THIN FILM PACKAGING METHOD, THIN FILM PACKAGING DEVICE, AND SOLAR CELL**

(71) Applicant: Hanergy New Material Technology Co., Ltd., Yanqi Industrial Development Zone Huairou District Beijing (CN)
(72) Inventor: Zhang, Pengju, Beijing (CN); Tan, Xiaotian, Beijing (CN); Yu, Zhijian, Beijing (CN); Zhang, Yu, Beijing (CN); Li, Shengchun, Beijing (CN)
(74) Representative: Soria Parra, Manuel

(57) **Abstract**

The present invention relates to a thin film packaging method and device, a thin film packaging system, and a solar cell. The film packaging method includes: forming an inorganic barrier film on an electronic device formed with a metal oxide thin film, the inorganic barrier film being disposed on a surface of the metal oxide thin film; and performing a reduction treatment on the electronic device to cause a reduction reaction of the metal oxide thin film to obtain a corresponding molten metal, wherein the molten metal is filled and cured in a pore of the inorganic barrier film. In the technical solution, the pore in the inorganic barrier layer can be compensated, thereby improving the effect of the film packaging.

## Description

### TECHNICAL FIELD

The present invention relates to the field of semiconductor packaging technologies, and in particular, to a thin film packaging method, a thin film packaging device, and a solar cell.

### BACKGROUND

In recent years, the increasingly prominent traditional energy issues have promoted the rapid development of new energy sources. Especially the clean energy represented by solar energy has received high degree and extensive attention. Since the core material in the solar cell module is very sensitive to moisture, and exposure to the atmosphere is likely to cause attenuation of power generation efficiency, the use of an effective packaging structure is important for ensuring the power generation efficiency of the solar cell module.

At present, the common packaging structure includes an alternately stacked packaging structure of an organic thin film and an inorganic thin film. However, since the inorganic thin film is usually small in thickness and has defects such as holes or cracks, the water vapor still easily invades slowly. Therefore, the alternately stacked structure is still difficult to maintain a good packaging effect for a long time. In view of this, it is urgent to develop a packaging structure having a good waterproof effect to ensure the performance of the solar cell module.

### SUMMARY

To overcome the problems in the related art, embodiments of the present invention provide a thin film packaging method and device, a thin film packaging system, and a solar cell. The technical solutions are as follows.

According to a first aspect of the embodiments of the present invention, there is provided a thin film packaging method, including:
forming an inorganic barrier film on an electronic device formed with a metal oxide thin film, the inorganic barrier film being disposed on a surface of the metal oxide thin film; and
performing a reduction treatment on the electronic device to cause a reduction reaction of the metal oxide thin film to obtain a corresponding molten metal, wherein the molten metal is filled and cured in a pore of the inorganic barrier film.

In one embodiment, the electronic device formed with the metal oxide thin film includes an electronic device body and a metal oxide thin film on a surface of the electronic device body, the metal oxide thin film being an electrode of the electronic device.

In one embodiment, the metal oxide thin film is a transparent metal oxide conductive thin film.

In one embodiment, forming an inorganic barrier film on the electronic device formed with a metal oxide thin film includes:
forming a first barrier film and a second barrier film sequentially on a side of the electronic device facing the inorganic barrier film;
forming the metal oxide thin film on a side of the second barrier film facing the inorganic barrier film; and
forming the inorganic barrier film on a surface of the metal oxide thin film,
wherein the first barrier film is made of an inorganic thin film material, and the second barrier film is made of an organic thin film material.

In one embodiment, the metal oxide thin film includes a transparent metal oxide conductive thin film or a transparent metal oxide non-conductive thin film.

In one embodiment, performing a reduction treatment on the electronic device includes:
performing plasma surface treatment on the electronic device.

In one embodiment, the plasma surface treatment includes a hydrogen plasma surface treatment.

According to a second aspect of the embodiments of the present invention, there is provided a thin film packaging system, including:
a coating apparatus configured to form an inorganic barrier film on an electronic device formed with a metal oxide thin film, the inorganic barrier film being disposed on a surface of the metal oxide thin film; and
a reduction apparatus configured to perform a reduction treatment on the electronic device to cause a reduction reaction of the metal oxide thin film to obtain a corresponding molten metal, which is filled and cured in a pore of the inorganic barrier film.

In one embodiment, the coating apparatus includes a physical vapor deposition apparatus or a chemical vapor deposition apparatus, and the reduction apparatus includes a plasma reduction apparatus.

In one embodiment, each of the coating apparatus and the reduction apparatus includes a plasma enhanced chemical vapor deposition apparatus.

According to a third aspect of the embodiments of the present invention, there is provided a thin film packaging device, including:
an electronic device, including an electronic device body;
a metal oxide thin film on one side of the electronic device body; and
an inorganic barrier film on a surface of the metal oxide thin film,
wherein a pore of the inorganic barrier film is filled with a corresponding metal obtained from a reduction reaction of the metal oxide thin film.

In one embodiment, the metal oxide thin film is an electrode of the electronic device and is disposed on a surface of the electronic device body.

In one embodiment, the metal oxide thin film is a transparent metal oxide conductive thin film.

In one embodiment, the thin film packaging device further includes:
a first barrier film on a side of the electronic device body facing the metal oxide thin film, the first barrier film being made of an inorganic thin film material; and
a second barrier film on a side of the first barrier film facing the metal oxide thin film, and the second barrier film being made of an organic thin film material,
wherein the metal oxide thin film is disposed between the second barrier film and the inorganic barrier film.

In one embodiment, the metal oxide thin film includes a transparent metal oxide conductive thin film or a transparent metal oxide non-conductive thin film.

In one embodiment, the thin film packaging device includes a plurality of sets of packaging layers composed of the metal oxide thin film and the inorganic barrier film on the surface of the metal oxide thin film.

According to a fourth aspect of the embodiments of the present invention, there is provided a solar cell including the above-described thin film packaging device, wherein the electronic device includes a solar cell module.

The technical solutions provided by the embodiments of the present invention may include the following beneficial effects.

In the technical solutions, on the one hand, the metal oxide thin film and the inorganic barrier layer are formed on the surface of the electronic device, so that the inorganic barrier layer can be used to prevent the water vapor from eroding the electronic device under the inorganic barrier layer. On the other hand, by performing high-temperature reduction treatment on the electronic device, the metal oxide thin film exposed through the pore in the inorganic barrier layer can be subjected to a reduction reaction to generate a corresponding molten metal, and the molten metal can be filled and cured exactly in the pore, so that the pore in the inorganic barrier layer can be effectively compensated, thereby improving the effect of the film packaging, in order to ensure the working efficiency and the service life of the electronic device.

It should be understood that both the foregoing general description and the following detailed description are exemplary and explanatory only and are not restrictive of the invention.

### BRIEF DESCRIPTION OF THE DRAWINGS

The accompanying drawings herein, which are incorporated in and constitute a part of this specification, illustrate embodiments consistent with the present invention and, together with the description, serve to explain the principles of the present invention.
Fig. 1 is a schematic diagram of a thin film packaging structure in the prior art;
Fig. 2 is a flow chart showing a thin film packaging method according to an exemplary embodiment.
Fig. 3 is a first process diagram of a thin film packaging method according to an exemplary embodiment;
Fig. 4 is a second process diagram of a thin film packaging method according to an exemplary embodiment;
Fig. 5 is a schematic structural diagram of an electronic device before reduction treatment according to an exemplary embodiment;
Fig. 6 is a schematic structural diagram of an electronic device before reduction treatment according to an exemplary embodiment;
Fig. 7 is a schematic structural diagram of an electronic device before reduction treatment according to an exemplary embodiment;
Fig. 8 is a structural block diagram of a thin film packaging system according to an exemplary embodiment;
Fig. 9 is a schematic diagram of a thin film packaging device according to an exemplary embodiment;
Fig. 10 is a schematic diagram of a thin film packaging device according to an exemplary embodiment; and
Fig. 11 is a schematic diagram of a thin film packaging device according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present invention. Instead, they are merely examples of devices and methods consistent with aspects related to the present invention as recited in the appended claims.

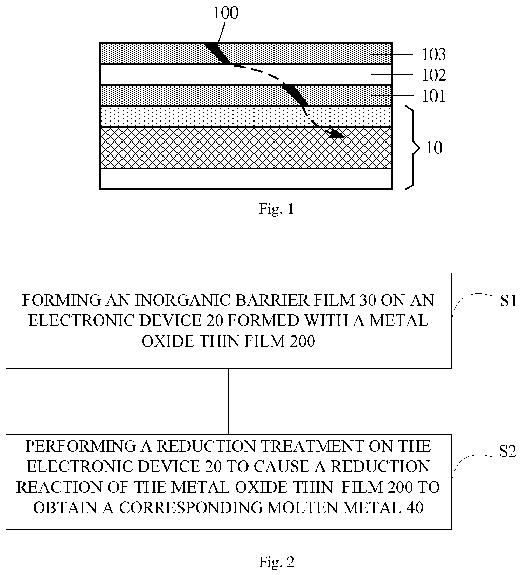

Considering that the core material of the solar cell module is very sensitive to moisture, it is necessary to adopt a specific packaging structure to prevent the intrusion of moisture, thereby ensuring the power generation efficiency of the solar cell. In the related art, an alternately laminated structure of an organic thin film and an inorganic thin film is mainly used to realize a thin film packaging of a solar cell module, but the packaging effect is not satisfactory. Taking the packaging structure shown in Fig. 1 as an example, an inorganic barrier film 101, an organic flat layer 102, and an inorganic protective film 103 are sequentially disposed on the surface of the solar cell module 10, thereby forming a multilayer packaging structure in which an organic thin film and an inorganic thin film are alternately formed. However, since the inorganic thin film is usually small in thickness and has some defects such as holes or cracks 100, the water vapor still easily invades slowly, and even if using a multilayer alternately structure of an organic thin film and an inorganic thin film, it is difficult to maintain the packaging effect for a long time.

In view of this, the technical solution provided by the embodiments of the present invention relates to a thin film packaging method, which can be applied to a thin film packaging of an electronic device such as a solar cell module. As shown in Fig. 2, the thin film packaging method may include the following steps.

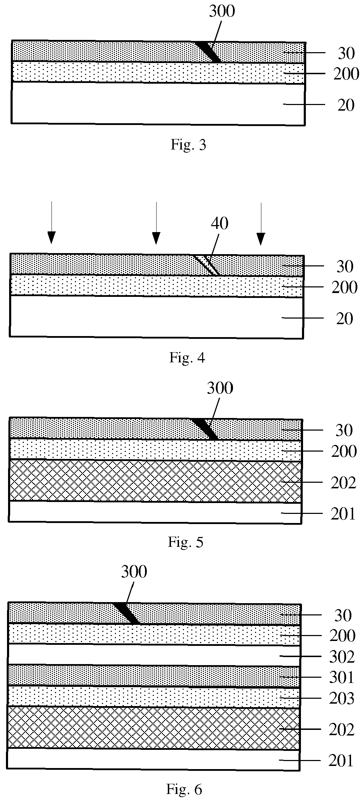

In step S1, as shown in Fig. 3, an inorganic barrier film 30 is formed on an electronic device 20 on which a metal oxide thin film 200 is formed.

Here, the inorganic barrier film 30 is disposed on the surface of the metal oxide thin film 200, and a minute pore 300 may exist in the inorganic barrier film 30.

In step S2, as shown in Fig. 4, the electronic device 20 is subjected to a reduction treatment to cause a reduction reaction of the metal oxide thin film 200 to obtain a corresponding molten metal 40.

The molten metal 40 is filled and cured in the pore 300 of the inorganic barrier film 30.

It should be noted that although the surface of the metal oxide thin film 200 is covered with the inorganic barrier film 30, the inorganic barrier film 30 may have some pores 300 thereon, and at a position corresponding to a pore 300, the metal oxide thin film 200 is actually exposed.

In the technical solution provided by the embodiment of the present invention, on the one hand, the metal oxide thin film 200 and the inorganic barrier layer 30 are formed on the surface of the electronic device 20, so that the inorganic barrier layer 30 can be used to prevent the water vapor from eroding the electronic device 20 under the inorganic barrier layer 30. On the other hand, by performing high-temperature reduction treatment on the electronic device 20, the metal oxide thin film 200 exposed through the pore 300 in the inorganic barrier layer 30 can be subjected to a reduction reaction to generate a corresponding molten metal 40, and the molten metal 40 can be filled and cured exactly in the pore 300, so that the pore 300 in the inorganic barrier layer 30 can be effectively compensated, thereby improving the effect of the film packaging, in order to ensure the working efficiency and the service life of the electronic device 20.

In the present example embodiment, the method of performing the reduction treatment on the electronic device 20 may include plasma surface treatment. The plasma as the reduction medium includes, but is not limited to, hydrogen plasma. Therefore, in the present embodiment, the electron device 20 can be subjected to a reduction treatment by hydrogen plasma, which can be generated by hydrogen ionization, and a gas such as nitrogen or argon can be used as a shielding gas.

Taking an ITO (Indium Tin Oxide) thin film as the metal oxide thin film 200 and performing a reduction treatment by hydrogen plasma, the conversion process of the reduction treatment is as follows:

In₂O₃+H⁺→In+H₂O

The hydrogen ion H⁺ has strong reducibility. Therefore, when the hydrogen ion H⁺ comes into contact with In₂O₃ in ITO, In₂O₃ is reduced to form a corresponding metal indium In. The plasma surface treatment process is carried out in a vacuum system such as a PECVD (Plasma Enhanced Chemical Vapor Deposition) apparatus. On the one hand, the high temperature environment of the plasma surface treatment causes the formed metal indium to be in a molten state and filled in the pore 300 of the inorganic barrier layer 30, and to be gradually cured during the subsequent cooling process to obtain a solid metal indium. On the other hand, the vacuum environment of the plasma surface treatment causes the generated water vapor to be discharged by the vacuum system. It should be noted that the plasma surface treatment process can be debugged for the power of the apparatus and the flow rate of the gas according to actual conditions, so as to optimize the process conditions.

In one embodiment, as shown in Fig. 5, the electronic device 20 formed with the metal oxide thin film 200 may include a base substrate 201; the electronic device body 202 (such as the photoelectric functional layer of the solar cell module) on the base substrate 201; and the metal oxide thin film 200 on the surface of the electronic device body 202. The metal oxide thin film 200 is the electrode of the electronic device 20, by which the repair of the inorganic barrier film 30 can be facilitated.

The metal oxide thin film 200 may be a transparent metal oxide conductive thin film such as an ITO thin film and an AZO (Aluminum doped Zinc Oxid) thin film. On one hand, it can ensure the conductivity of the electrode, and on the other hand the light receiving area of the electronic device body 202 (such as the photoelectric functional layer) will not be affected.

When the metal oxide thin film 200 is the AZO thin film, Zinc oxide can be reduced by gas, e.g., CO, as follows:

ZnO+CO=Zn+CO₂

The resulting molten zinc may also be filled and cured in the pore of the inorganic barrier film, so that the pore in the inorganic barrier film can be effectively compensated, thereby improving the effect of the film packaging.

In this case, the specific process of the step S1 is as follows. Referring to Fig. 5, an electronic device body 202 (such as a photoelectric functional layer of a solar cell module) is first formed on a base substrate 201. Then, a metal oxide thin film 200 is formed, as an electrode of the electronic device 20 (such as the solar cell module), on the surface of the electronic device body 202. Next, an inorganic barrier film 30 such as a silicon nitride thin film or a silicon oxide thin film is formed, as a packaging isolation layer of the electronic device 20, on the surface of the metal oxide thin film 200. The metal oxide thin film 200 such as an ITO thin film and an inorganic barrier film 30 such as a silicon nitride thin film may be formed by evaporation deposition or sputtering deposition, or may be formed by PECVD.

Based on this, in the present embodiment, the inorganic barrier film 30 is formed directly on the electrode of the electronic device 20 to obtain the structure in which the inorganic barrier film 30 is disposed on the surface of the metal oxide thin film 200. The structure is further subjected to high-temperature reduction treatment. In this way, as the first layer of the electronic device 20, the inorganic barrier film 30 (i.e. the inorganic barrier film 30 closest to the electronic device body 202) can be repaired, thereby achieving a sealing barrier effect of the inorganic barrier film 30.

In another embodiment, as shown in Fig. 6, the electronic device 20 formed with the metal oxide thin film 200 may include a base substrate 201; an electronic device body 202 and a conductive layer 203 sequentially disposed on the base substrate 201 (such as a photoelectric functional layer and an electrode of the solar cell module); a first barrier film 301 and a second barrier film 302 sequentially disposed on the conductive layer 203; and a metal oxide thin film 200 on the second barrier film 302. The metal oxide thin film 200 is a layer of a metal oxide thin film additionally formed for repairing the inorganic barrier film 30.

The first barrier film 301 can be an inorganic thin film such as a silicon oxide thin film, a silicon nitride thin film, an aluminum oxide thin film, a diamond-like thin film, or the like. The inorganic thin film can be used as a packaging isolation layer of the electronic device 20. The second barrier film 302 can be an organic thin film such as photoresist coating. The organic thin film can be used as an organic isolation layer of the electronic device 20, and can also achieve a planarization effect to facilitate the preparation of a subsequent film layer.

In this embodiment, the metal oxide thin film 200 may be a transparent metal oxide conductive thin film such as an ITO thin film and an AZO thin film, and may also be a transparent metal oxide non-conductive thin film such as IGZO (Indium Gallium Zinc Oxide) thin film. It is not particularly limited as long as it is a transparent metal oxide capable of undergoing a high-temperature reduction reaction and forming a molten metal.

In this case, the specific process of the step S1 is as follows. Referring to Fig. 6, an electronic device body 202 (such as a photoelectric functional layer of a solar cell module) is first formed on a base substrate 201. Then, a conductive layer 203 is formed, for example, as an electrode of the solar cell module, on the surface of the electronic device body 202. Next, a first barrier film 301 such as an inorganic thin film and a second barrier film 302 such as an organic thin film are sequentially formed on the conductive layer 203. Then a metal oxide thin film 200 such as an ITO thin film is formed on the second barrier film 302. Finally, an inorganic barrier film 30 such as a silicon nitride thin film or a silicon oxide thin film is formed on the surface of the metal oxide thin film 200. The metal oxide thin film 200 such as an ITO thin film, the first barrier thin film 301 such as a silicon nitride thin film, and the inorganic barrier film 30 such as a silicon nitride thin film may be formed by evaporation deposition or sputtering deposition, or by PECVD. The second barrier film 302 such as an organic resin-based photoresist coating layer can be formed by solution coating, sol-gel, blade coating, screen printing, or printing, for example. Further, the metal oxide thin film 200 and the conductive layer 203 may be the same substance/material, and in a case where multiple layers of inorganic barrier films are required, one layer of the metal oxide thin film 200 or the conductive layer 203 is provided under each layer of the inorganic barrier films.

Based on this, in the present embodiment, on the one hand, by forming the first barrier film 301, the second barrier film 302, and the inorganic barrier film 30 over the electronic device 20, an alternating structure of the organic thin film and the inorganic thin film can be formed thereby improving the effect of thin film packaging. On the other hand, an additional metal oxide thin film 200 is added between the second barrier film 302 and the inorganic barrier film 30 to obtain a structure in which the inorganic barrier film 30 is disposed on the surface of the metal oxide thin film 200, and the structure can be subjected to high-temperature reduction treatment. Thus, the outermost inorganic barrier film 30 of the electronic device 20 can be repaired, thereby achieving the sealing barrier effect of the inorganic barrier film 30.

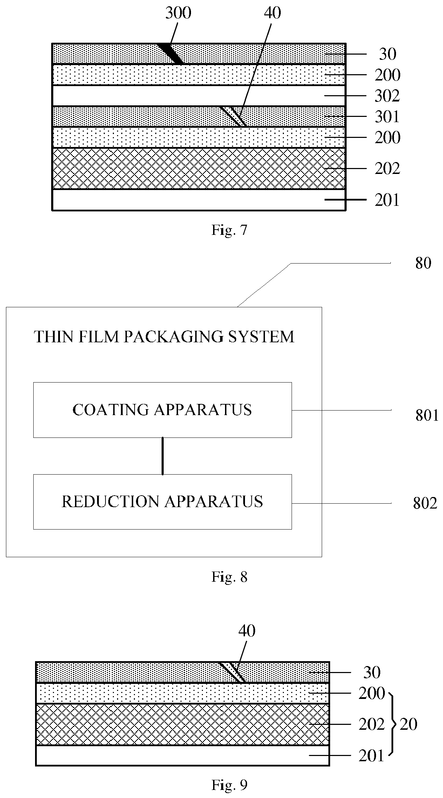

It should be noted that the above two embodiments may be used alone or in combination. Based on this, when the above two embodiments are used in combination, as shown in Fig. 7, the metal oxide thin film 200 which can serve as an electrode, and the first barrier film 301 composed of inorganic thin film on the surface of the metal oxide thin film 200 are not only formed on the surface of the electronic device body 202, but also subjected to reduction treatment. In addition, a metal oxide thin film 200, and an inorganic barrier film 30 on the surface of the metal oxide thin film 200 are formed over the second barrier layer 302, and subjected to reduction treatment. In this way, it can effectively repair each layer of the inorganic thin film isolation layers, thereby significantly improving the thin film packaging effect.

In the exemplary embodiment, the thin film packaging method may further include forming over the electronic device 20 a plurality of sets of packaging layers composed of the metal oxide thin film 200 and the inorganic barrier film 30 on the surface of the metal oxide thin film 200. The formation method and the reduction treatment process of each set of packaging layers are the same as those of the above embodiments, and therefore will not be described herein. Based on this, the overall thickness and flexibility of the thin film packaging device need to be considered in actual production, so as to determine the number of the above packaging layers according to actual conditions.

Based on the above-mentioned thin film packaging method, the technical solution provided by the embodiments of the present invention further relates to a thin film packaging system 80, as shown in Fig. 8, including a coating apparatus 801, and a reduction apparatus 802.

The coating apparatus 801 is configured to form an inorganic barrier film 30 on the electronic device 20 on which the metal oxide thin film 200 is formed. The inorganic barrier film 30 is disposed on the surface of the metal oxide thin film 200, and there may be a minute pore 300 in the inorganic barrier film 30.

The reduction apparatus 802 is configured to perform a reduction treatment on the electronic device 20 to cause the metal oxide thin film 200 to be subjected to a reduction reaction, to obtain a corresponding molten metal 40, which is filled and cured in the pore 300 of the inorganic barrier film 30.

The coating apparatus 801 may include a physical vapor deposition apparatus or a chemical vapor deposition apparatus, such as an evaporation deposition apparatus and a sputtering deposition apparatus. The reduction apparatus 802 may include a plasma reduction apparatus such as a PECVD apparatus or the like.

Based on this, both the coating apparatus 801 and the reduction apparatus 802 in the present exemplary embodiment can adopt a PECVD apparatus, which can reduce the number of apparatuses required in the thin film packaging process, thereby saving process cost.

The technical solution provided by the embodiments of the present invention further relates to a thin film packaging device, and as shown in Fig. 9 to Fig. 11, the thin film packaging device includes an electronic device 20, a metal oxide thin film 200 and an inorganic barrier film 30.

The electronic device 20 includes an electronic device body 202, such as a photoelectric functional layer of a solar cell module.

The metal oxide thin film 200 is disposed on one side of the electronic device body 202, such as the light receiving surface side of the solar cell module.

The inorganic barrier film 30 is disposed on the surface of the metal oxide thin film 200, and a pore 300 of the inorganic barrier film 30 is filled with metal 40 obtained from a reduction reaction of the metal oxide thin film 200.

It should be noted that the metal 40 in the present embodiment is a metal obtained when the molten metal formed by the reduction reaction is further cooled and cured in the pore 300 of the inorganic barrier film 30.

In the technical solution provided by the embodiment of the present invention, the metal oxide thin film 200 and the inorganic barrier layer 30 are formed on the surface of the electronic device 20, so that the inorganic barrier layer 30 can be used to prevent the water vapor from eroding the electronic device 20. The metal oxide thin film 200 is further subjected to reduction treatment to obtain the metal 40 filled in the pore 300 of the inorganic barrier layer 30, so that the pore 300 in the inorganic barrier layer 30 can be effectively compensated, thereby improving the effect of the thin film packaging, so as to ensure the working efficiency and the service life of the electronic device 20.

In one embodiment, referring to Fig. 9, the metal oxide thin film 200 serves as an electrode of the electronic device 20 and is disposed on a surface of the electronic device body 202. The metal oxide thin film 200 may be a transparent metal oxide conductive thin film, such as ITO or AZO. On the one hand, the conductive performance of the electrode can be ensured, and on the other hand, the light receiving area of the electronic device body 202 such as the photoelectric functional layer will not be affected.

In this case, the thin film packaging device may include a base substrate 201; an electronic device body 202 (such as a photoelectric functional layer of a solar cell module) on the base substrate 201; a metal oxide thin film 200 on the surface of the electronic device body 202; and an inorganic barrier film 30 on the surface of the metal oxide thin film 200. The metal oxide thin film 200 serves as an electrode of the electronic device 20. Based on this, in the present embodiment, it can repair the inorganic barrier film 30 by means of the electrode, thereby ensuring the sealing barrier effect of the inorganic barrier film 30.

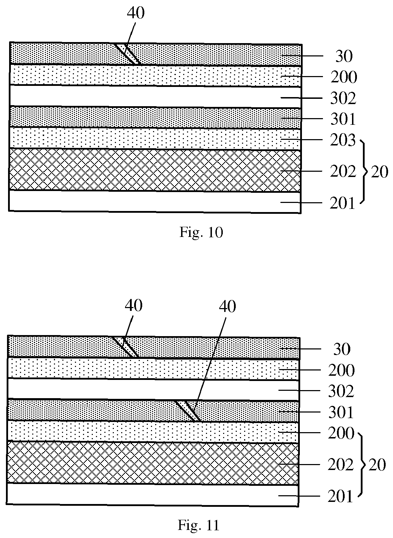

In another embodiment, as shown in Fig. 10, the thin film packaging device may further include a conductive layer 203 on the surface of the electronic device body 202; and a first barrier film 301 and a second barrier film 302 between the conductive layer 203 and the metal oxide thin film 200. The first barrier film 301 is disposed on the side adjacent to the conductive layer 203, and the second barrier film 302 is disposed on the side adjacent to the metal oxide thin film 200. The metal oxide thin film 200 is disposed between the second barrier film 302 and the inorganic barrier film 30.

In the present embodiment, the metal oxide thin film 200 may be a transparent metal oxide conductive thin film such as an ITO thin film or an AZO thin film, and may also be a transparent metal oxide non-conductive thin film such as an IGZO thin film. In addition, the first barrier film 301 may be an inorganic thin film such as a silicon oxide thin film, a silicon nitride thin film, an aluminum oxide thin film, a diamond-like thin film or the like, and the inorganic thin film may serve as a packaging isolation layer of the electronic device 20. The second barrier film 302 may be an organic thin film such as a photoresist coating. The organic thin film can be used as an organic isolation layer of the electronic device 20, and can also be planarized.

In this case, the thin film packaging device may include a base substrate 201; an electronic device body 202 (such as a photoelectric functional layer of a solar cell module) on the base substrate 201; a conductive layer 203 (such as an electrode of the solar cell module) on the surface of the electronic device body 202; a first barrier film 301 such as an inorganic thin film and a second barrier film 302 such as an organic thin film sequentially disposed on the side of the conductive layer 203 facing away from the substrate 201; a metal oxide thin film 200 disposed on the side of the second barrier film 302 facing away from the base substrate 201; and an inorganic barrier film 30 on the surface of the metal oxide thin film 200.

Based on this, in the present embodiment, by adding the first barrier film 301 and the second barrier film 302 between the electronic device 20 and the inorganic barrier film 30, an alternating structure of the organic thin film and the inorganic thin film can be obtained, thereby improving the effect of the thin film packaging. In addition, by additionally adding a metal oxide thin film 200 between the second barrier film 302 and the inorganic barrier film 30, the inorganic barrier film 30 can be repaired by the metal oxide thin film 200, thereby ensuring the sealing barrier effect of the inorganic barrier film 30.

It should be noted that the above two embodiments may be used alone or in combination. Based on this, when the above two embodiments are used in combination, as shown in Fig. 11, not only the metal oxide thin film 200 which can serve as an electrode, and the first barrier film 301 composed of an inorganic thin film on the surface of the metal oxide thin film 200 are formed on the surface of the electronic device body 202, but also the metal oxide thin film 200 and an inorganic barrier film 30 on the metal oxide thin film 200 are formed over the second barrier layer 302, so that each layer of the inorganic thin film isolation layers can be repaired, which can significantly improve the thin film packaging effect.

In the exemplary embodiment, the thin film packaging device may include a plurality of sets of packaging layers composed of the metal oxide thin film 200 and the inorganic barrier film 30 on the surface of the metal oxide thin film 200. The structure of each set of packaging layers and the formation method thereof are the same as that of the above embodiments, and therefore will not be described again here. Based on this, the overall thickness and flexibility of the thin film packaging device need to be considered in actual production, so as to determine the number of the above packaging layers according to actual conditions.

The technical solution provided by the embodiments of the invention further relates to a solar cell including the above-mentioned thin film packaging device. The electronic device in the thin film packaging device may serve as a solar cell module in the solar cell, such as a photoelectric functional layer and an electrode of the solar cell module.

Other embodiments of the invention will be apparent to those skilled in the art from consideration of the specification and practice of the invention disclosed here. This application is intended to cover any variations, uses, or adaptations of the invention following the general principles thereof and including such departures from the present invention as come within known or customary practice in the art. It is intended that the specification and examples be considered as exemplary only, with a true scope of the invention being indicated by the following claims.

It will be appreciated that the present invention is not limited to the exact construction that has been described above and illustrated in the accompanying drawings, and that various modifications and changes may be made without departing from the scope thereof. It is intended that the scope of the invention only be limited by the appended claims.

## Claims

1. A thin film packaging method, comprising:
forming (S1) an inorganic barrier film (30) on an electronic device (20) formed with a metal oxide thin film (200), wherein the inorganic barrier film (30) is disposed on a surface of the metal oxide thin film (200); and
performing (S2) a reduction treatment on the electronic device (20) to cause a reduction reaction of the metal oxide thin film (200) to obtain a corresponding molten metal (40), wherein the molten metal (40) is filled and cured in a pore (300) of the inorganic barrier film (30).

2. The thin film packaging method according to claim 1, wherein the electronic device (20) formed with the metal oxide thin film (200) comprises an electronic device body (202) and a metal oxide thin film (200) on a surface of the electronic device body (202), and the metal oxide thin film (200) is an electrode of the electronic device (20).

3. The thin film packaging method according to claim 2, wherein the metal oxide thin film (200) is a transparent metal oxide conductive thin film.

4. The thin film packaging method according to claim 1, wherein forming (S1) an inorganic barrier film (30) on an electronic device (20) formed with a metal oxide thin film (200) comprises:
forming a first barrier film (301) and a second barrier film (302) sequentially on a side of the electronic device (20) facing the inorganic barrier film (30);
forming the metal oxide thin film (200) on a side of the second barrier film (302) facing the inorganic barrier film (30); and
forming the inorganic barrier film (30) on a surface of the metal oxide thin film (200),
wherein the first barrier film (301) is made of an inorganic thin film material, and the second barrier film (302) is made of an organic thin film material.

5. The thin film packaging method according to claim 4, wherein the metal oxide thin film (200) comprises a transparent metal oxide conductive thin film or a transparent metal oxide non-conductive thin film.

6. The thin film packaging method according to claim 1, wherein performing (S2) a reduction treatment on the electronic device (20) comprises:
performing plasma surface treatment on the electronic device (20).

7. The thin film packaging method of claim 6, wherein the plasma surface treatment comprises a hydrogen plasma surface treatment.

8. A thin film packaging device, comprising:
an electronic device (20), comprising an electronic device body (202);
a metal oxide thin film (200) on one side of the electronic device body (202); and
an inorganic barrier film (30) on a surface of the metal oxide thin film (200),
wherein a pore (300) of the inorganic barrier film (200) is filled with a corresponding metal (40) obtained from a reduction reaction of the metal oxide thin film (200).

9. The thin film packaging device according to claim 8, wherein the metal oxide thin film (200) is an electrode of the electronic device (20) and is disposed on a surface of the electronic device body (202).

10. The thin film packaging device according to claim 9, wherein the metal oxide thin film (200) is a transparent metal oxide conductive thin film.

11. The thin film packaging device according to claim 9, wherein the thin film packaging device further comprises:
a first barrier film (301) on a side of the electronic device body (202) facing the metal oxide thin film (200), wherein the first barrier film (301) is made of an inorganic thin film material; and
a second barrier film (302) on a side of the first barrier film (301) facing the metal oxide thin film (200), wherein the second barrier film (302) is made of an organic thin film material,
wherein the metal oxide thin film (200) is disposed between the second barrier film (302) and the inorganic barrier film (30).

12. The thin film packaging device according to claim 11, wherein the metal oxide thin film (200) comprises a transparent metal oxide conductive thin film or a transparent metal oxide non-conductive thin film.

13. The thin film packaging device according to claim 9, wherein the thin film packaging device comprises a plurality of sets of packaging layers composed of the metal oxide thin film (200) and the inorganic barrier film on the surface of the metal oxide thin film (200).

14. A solar cell, comprising the thin film packaging device according to any one of claims 8 to 13, wherein the electronic device (20) comprises a solar cell module.
